# EUROPEAN PATENT APPLICATION

(11) **EP 4 592 158 A1**
(43) Date of publication of application: **30.07.2025**
(21) Application number: 23871540.3
(22) Date of filing: 16.08.2023
(51) Int. Cl.: B61B 13/06, B61B 3/02, B65G 1/00, H01L 21/677

(54) **RAIL-GUIDED CARRIER SYSTEM**

(30) Priority: 29.09.2022 JP 2022156059
(71) Applicant: Murata Machinery, Ltd., Kyoto-shi, Kyoto 601-8326 (JP)
(72) Inventor: TORAZAWA, Masayoshi, Inuyama-shi, Aichi 484-8502 (JP)
(74) Representative: Stöckeler, Ferdinand
(86) International application number: PCT/JP2023/029633
(87) International publication number: WO 2024/070298

(57) **Abstract**

The overhead traveling vehicle system includes a track in which a plurality of first rails extends in an X direction and a plurality of second rails extends in a Y direction in a grid, and a traveling vehicle travels on a pair of the first rails adjacent to each other in the Y direction and travels on a pair of the second rails adjacent to each other in the X direction, in which each of the first rail and the second rail has a first surface on which a cell recognition mark is disposed and a second surface on which a position recognition mark is disposed, the second surface, when viewed from a center of a cell in plan view, being disposed outside the first surface and being inclined toward the traveling vehicle 2 side with respect to the first surface.

## Description

### Technical Field

One aspect of the present disclosure relates to tracked cart systems.

### Background Art

As a technology related to tracked cart systems, Patent Document 1 discloses an overhead transport vehicle system. This overhead transport vehicle system includes: rails including a first rail (first track) extending in a first direction and a second rail (second track) extending in a second direction perpendicular to the first direction; and a tracked cart (overhead transport vehicle) traveling along the rails. The first and the second rails are disposed in a grid to form a plurality of cells (compartments) in plan view. The tracked cart moves in the first direction by traveling on a pair of the first rails adjacent to each other, and moves in a second direction by traveling on a pair of the second rails adjacent to each other. The tracked cart can move from one cell to another cell adjacent to the one cell by traveling in the first or the second direction.

### Citation List

### Patent Literature

[Patent Document 1] Japanese Patent No. 7040638

### Summary of Invention

### Technical Problem

Marks indicating predetermined information detectable by sensors provided on the tracked cart are disposed on the first rail and the second rail constituting the above rails. By detecting the marks by the sensors to acquire information, control based on the information becomes possible for the tracked cart. Here, there is a case in which two types of marks indicating different types of information from each other are desired to be disposed at the same location in the traveling direction of the rail. However, the above conventional rail has only one surface where a mark is to be disposed, and thus two types of marks cannot be disposed thereon.

To address these problems, it is conceivable to form two surfaces on the rail where the two types of marks are respectively disposed. In this case, the tracked cart is configured so that the sensor faces the surface where the mark is placed, but there is demand to make the size of the tracked cart compact, including the configuration in which such a sensor is disposed.

Therefore, an object of one aspect of the present disclosure is to provide a tracked cart system capable of disposing two types of marks different from each other on the rail, while suppressing an increase in the size of the tracked cart.

### Solution to Problem

A tracked cart system according to one aspect of the present disclosure includes: a track in which a plurality of first rails extending in a first direction and a plurality of second rails extending in a second direction orthogonal to the first direction are disposed in a grid; and a tracked cart configured to move in the first direction when a traveling part travels on a pair of the first rails adjacent to each other in the second direction, and to move in the second direction when the traveling part travels on a pair of the second rails adjacent to each other in the first direction, in which the tracked cart has a first sensor configured to acquire first information from a first mark indicating the first information, and a second sensor configured to acquire second information that is information different from the first information from a second mark indicating the second information, each of the first rail and the second rail has a first surface that faces the first sensor and on which the first mark is disposed, and a second surface that faces the second sensor and on which the second mark is disposed, the second surface having, when viewed from a center of a cell serving as a space enclosed by the pair of first rails and the pair of second rails in plan view, the second surface that is disposed outside the first surface and is inclined on the tracked cart side with respect to the first surface.

In the tracked cart system of this configuration, each of the first rail and the second rail forming the rails are provided with a first surface and a second surface that is different from the first surface, and thus when each of two different types of marks is disposed on a corresponding surface, two types of marks different from each other can be disposed on the same location in the traveling direction of the rail. In addition, in the tracked cart system of this configuration, the second surface disposed outside the first surface when viewed from the center of the cell in plan view is disposed to be inclined toward the tracked cart side with respect to the first surface. Consequently, there is no need to provide the second sensor to protrude from the tracked cart in order to make the second sensor face the second surface, thereby suppressing an increase in the size of the tracked cart.

A tracked cart system according to one aspect of the present disclosure may further include a control section configured to control the tracked cart, in which either the first mark or the second mark may be a position recognition mark indicating position information on the track, either the first sensor or the second sensor configured to face the position recognition mark may be disposed to face either the first surfaces or the second surfaces of the pair of first rails where the position recognition mark is disposed when the tracked cart moves in the first direction, may be disposed to face either the first surfaces or the second surfaces of the pair of second rails where the position recognition mark is disposed when the tracked cart moves in the second direction, and may be four position recognition sensors configured to acquire the position information from the position recognition mark, and the control section may be configured to, based on the position information acquired by the position recognition sensors, derive a shift amount between a predetermined position in the cell and a stop position of the tracked cart. In this case, it is possible to detect a position shift when the tracked cart stops.

In the tracked cart system according to one aspect of the present disclosure, the tracked cart may have a transfer device configured to transfer an object, and the control section may control a drive amount of the transfer device during moving of the object in a horizontal direction based on the shift amount. In this case, even in a case in which the tracked cart is not stopped at a predetermined position in the cell, the position to which the object is transferred by the transfer device is adjusted, so the object can be accurately transferred to a predetermined transfer position.

In the tracked cart system according to one aspect of the present disclosure, the tracked cart may have the transfer device configured to transfer an object and a horizontal swiveling mechanism configured to horizontally swivel around a third direction orthogonal to both the first and the second directions, and the control section may control the drive amount of the horizontal swiveling mechanism during horizontal swiveling of the object based on the shift amount. In this case, even in a case in which the tracked cart is not stopped at a predetermined position in the cell, the position to which the object is transferred by the transfer device is adjusted by the horizontal swiveling mechanism, so that the object can be transferred more accurately to the predetermined transfer position.

In the tracked cart system according to one aspect of the present disclosure, the control section may control the traveling part so that the tracked cart moves to a predetermined position in the cell based on the shift amount. In this case, even in a case in which the tracked cart is not stopped at a predetermined position in the cell, the position of the tracked cart is adjusted, so that the object can be more accurately transferred to the predetermined transfer position.

### Advantageous Effects of Invention

According to an aspect of the present disclosure, it is possible to provide a tracked cart system capable of disposing two types of marks different from each other on the rail while suppressing an increase in the size of the tracked cart.

### Brief Description of Drawings

[FIG. 1] FIG. 1 is a perspective view illustrating an example of an overhead traveling vehicle system according to an embodiment.
[FIG. 2] FIG. 2 is an exploded perspective view illustrating four rail units constituting a rail assembly in FIG. 1 and a connecting members configured to link those rail units together.
[FIG. 3] FIG. 3 is a side view of a traveling vehicle in FIG. 1.
[FIG. 4] FIG. 4 is a perspective view illustrating the traveling vehicle in FIG. 1.
[FIG. 5] FIG. 5 is a perspective view illustrating only a rail portion of a rail assembly.
[FIG. 6] FIG. 6 is a sectional view illustrating a connecting part between a plurality of rail units.
[FIG. 7] FIG. 7 is a perspective view illustrating the rail unit in FIG. 2.
[FIG. 8] FIG. 8 is a schematic cross-sectional view of the first rail when cut in a plane perpendicular to the X direction.
[FIG. 9] FIG. 9 is a block diagram illustrating a functional configuration of the traveling vehicle in FIG. 3.
[FIG. 10] FIGS. 10(a) and (b) are schematic plan views illustrating an example of the operation of the traveling vehicle during placing of an article onto the load port while controlling the drive amount of the slide mechanism.
[FIG. 11] FIGS. 11(a) and (b) are schematic plan views illustrating an example of the operation of the traveling vehicle during placing of an article onto the load port while controlling the drive amount of the rotation drive section.
[FIG. 12] FIGS. 12(a) and (b) are schematic plan views illustrating an example of the operation of the traveling vehicle during placing of an article onto the load port while controlling the drive amount of the traveling drive motor.

### Description of Embodiments

The following describes the embodiment of one aspect of the present disclosure with reference to the drawings. In the description of the drawings, identical elements are marked with the same symbol and redundant explanations are omitted. In the drawings, for convenience of explanation, each configuration according to the embodiment is represented at a different scale as appropriate. In some drawings, the XYZ Cartesian coordinate system is also shown. In the following description, this coordinate system will be referred to for ease of explanation. Hereafter, one direction along a horizontal plane is an X direction (first direction), a direction orthogonal to the X direction and along the horizontal plane is a Y direction (second direction), and a vertical direction is a Z direction orthogonal to both the X direction and the Y direction.

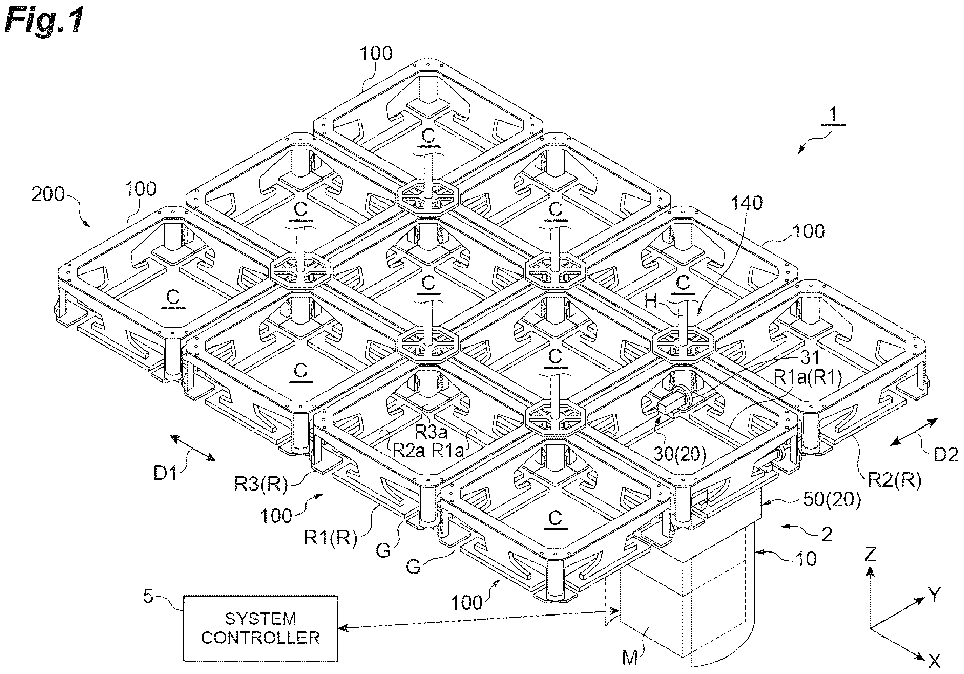

As illustrated in FIG. 1, the overhead traveling vehicle system (tracked cart system) 1 according to the embodiment is a grid system (transport system) 2 for transporting an article (object) M by means of an overhead traveling vehicle (tracked cart) 2 in a clean room of a semiconductor manufacturing plant, for example.

The track R is provided on or near the ceiling of a clean room or other building. The track R is provided adjacent to, for example, processing equipment, a stocker (automatic warehouse), or the like. The processing equipment includes, for example, exposure equipment, coater developers, deposition equipment, etching equipment, or the like, the processing equipment applying various types of processing to the semiconductor wafers in the articles M transported by the traveling vehicles 2. The stocker stores the articles M to be transported by the traveling vehicle 2.

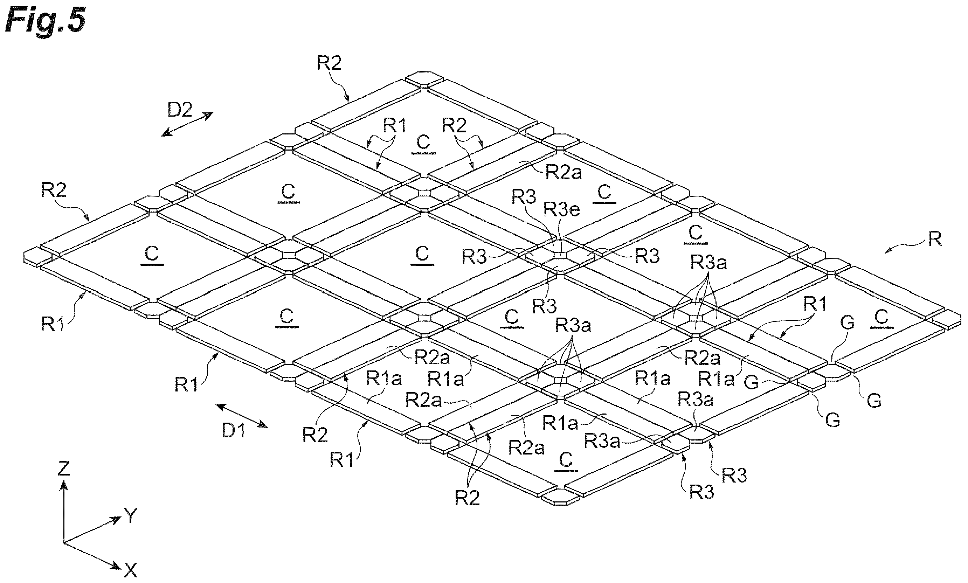

The tracks R are arranged in a grid in plan view (see also FIG. 5). The track R extends along the horizontal direction. In the present embodiment, the track R is constructed by a plurality of rail units 100 each including a first rail R1, a second rail R2, and an intersection rail R3, the rail units 100 being provided side by side in the X direction and in the Y direction. The overhead vehicle system 1 includes the rail units 100 provided side by side in the X direction and in the Y direction, and a plurality of connecting members 140 each configured to connect the rail units 100 to each other. The rail units 100 and the connecting members 140 form a rail assembly 200. The rail assembly 200 is hung from an unillustrated ceiling or the like by a plurality of hanging members H at a portion where the rail units 100 are connected to each other by the connecting members 140.

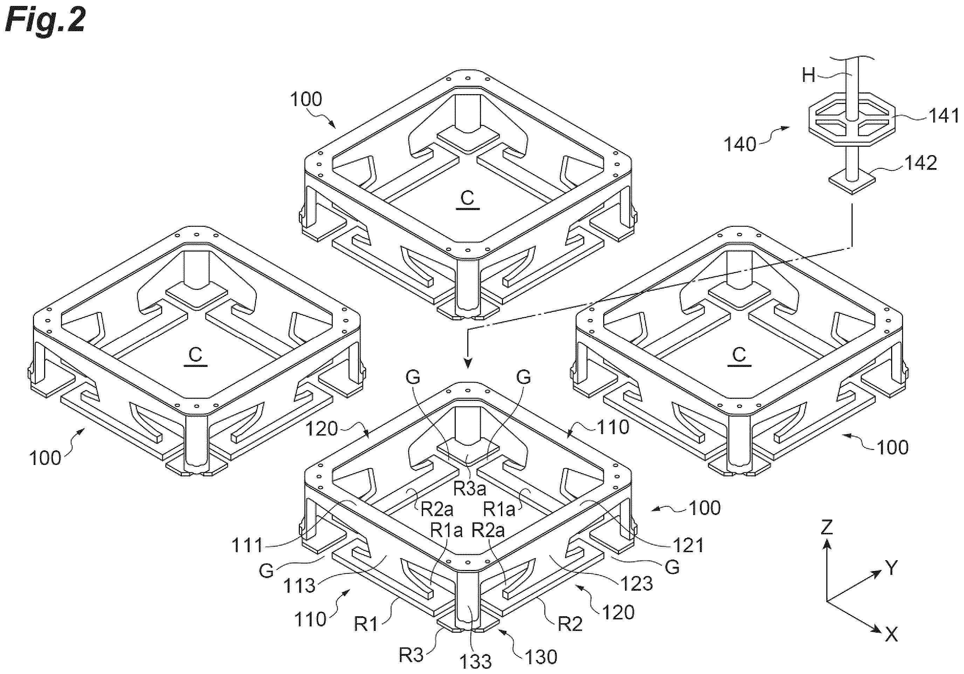

FIG. 2 is an exploded perspective view of the four rail units 100 constituting the rail assembly 200 in FIG. 1 and the connecting member 140 configured to connect those rail units 100. Each of the rail units 100 is a member of a rectangular shape (frame shape) and has the same configuration. Each rail unit 100 includes two first rail members 110 disposed along the X direction, two second rail members 120 disposed along the Y direction, and four intersection rail members 130 disposed such that gaps are formed on extensions of the first rail member 110 and the second rail member 120 (i.e., at the intersection of the grid). When the rail unit 100 is viewed in plan view, the two parallel first rail members 110 and the two parallel second rail members 120 are disposed in a square shape, and the four intersection rail members 130 are disposed at the apexes of the square.

Each rail unit 100 is made of metal, for example, and is a unit in which the first rail member 110, the second rail member 120, and the intersection rail member 130 are integrated after each thereof is molded. Each of the first rail members 110 includes a first beam portion 111 disposed at an upper end position of the rail unit 100 and extending in the X direction, a first rail R1 disposed at a lower end position of the rail unit 100 and extending in the X direction, and a first support wall 113 disposed between the first beam portion 111 and the first rail R1, and joined to the first beam portion 111 and the first rail R1. Each of the second rail members 120 includes a second beam portion 121 disposed at the upper end position of the rail unit 100 and extending in the Y direction, a second rail R2 disposed at the lower end position of the rail unit 100 and extending in the Y direction, and a second support wall 123 disposed between the second beam portion 121 and the second rail R2 and joined to the second beam portion 121 and the second rail R2. A plurality of the first beam portions 111 and a plurality of the second beam portions 121 form a grid structure, the structure extending along an XY plane at the upper end position of the rail assembly 200. The first support wall 113 extends along the XZ plane. The second support wall 123 extends along the YZ plane.

The intersection rail member 130 includes an intersection support column 133 extending along the Z direction (vertical direction) at the position where the first beam portion 111 and the second beam portion 121 are joined at right angles, and an intersection rail R3 at a lower end of the intersection support column 133.

As illustrated in FIG. 1 and FIG. 5, a plurality of the first rails R1 each extend along the X direction. A plurality of the second rails R2 each extend along the Y direction. In the track R, the first rails R1 and the second rails R2 are disposed in a grid in plan view. The track R is formed in a plurality of squares by the first rails R1 and the second rails R2. In other words, the track R forms a cell C, which is a space enclosed by a pair of the first rails R1 and a pair of the second rails R2 in plan view. The intersection rail R3 is disposed at a portion corresponding to the intersection between the first rail R1 and the second rail R2. The intersection rail R3 is adjacent to the first rail R1 at an interval between each other in the X direction, and has a portion (first rail) extending in the X direction. The intersection rail R3 is adjacent to the second rail R2 at an interval between each other in the Y direction, and has a portion (second rail) extending in the Y direction. The intersection rail R3 is used in every case when the traveling vehicle 2 travels along the first rail R1, when the traveling vehicle 2 travels along the second rail R2, or when the traveling vehicle 2 travels from the first rail R1 to the second rail R2 or from the second rail R2 to the first rail R1.

Each rail unit 100 forms a track R of a square shape (or a rectangular shape) corresponding to a single square in its interior thereof. When the rail units 100 are aligned in the X direction and the Y direction, the first rails R1 extend in a series in the X direction and the second rails R2 extend in a series in the Y direction. The two intersection rails R3 are disposed at intervals between one first rail R1 and another first rail R1 on the X direction line. On the Y direction line, the two intersection rails R3 are disposed at intervals between the one second rail R2 and another second rail R2. The track R is described in another viewpoint. When focusing on the four squares made of two squares aligned in the X direction and two squares aligned in the Y direction, the four intersection rails R3 adjacent to each other in the X direction and the Y direction are disposed at intervals (with respect to the first rail R1) between the two first rails R1 adjacent to each other in the Y direction and another two first rails R1 adjacent to each other in the Y direction. The same four intersection rails R3 as above are disposed at intervals (with respect to the second rail R2) between the two second rails R2 adjacent to each other in the X direction and another two second rails R2 adjacent to each other in the X direction.

In a rail assembly 200, the first rails R1, the second rails R2, and the intersection rails R3 are disposed at intervals from each other, and thereby a track R is constructed. A gap G corresponding to the above interval is formed between each first rail R1 and the corresponding intersection rail R3. A gap G corresponding to the above interval is formed between each second rail R2 and the corresponding intersection rail R3. The gap G in the track R has a constant size. Each of the first rails R1 includes a first travel surface R1a being flat and horizontal on its upper surface, and the traveling wheel 31 of the traveling vehicle 2 travels on the first travel surface R1a in the X direction (first traveling direction D1). Each of the second rails R2 includes a second travel surface R2a being flat and horizontal on its upper surface, and the traveling wheel 31 of the traveling vehicle 2 travels on the second travel surface R2a in the Y direction (second traveling direction D2). The intersection rail R3 includes an intersection travel surface R3a being flat and horizontal on its upper surface. The heights of the first travel surface R1a, the second travel surface R2a, and the intersection travel surface R3a are equal throughout the entire track R. The first travel surface R1a, the second travel surface R2a, and the intersection travel surface R3a are disposed on the same or substantially the same horizontal plane.

For example, there is no gap having a size of the gap G formed between the four intersection rails R3 described above. When the traveling vehicle 2 passes in a straight line through the rail units 100, the traveling wheel 31 of the traveling vehicle 2 travels on the intersection travel surface R3a. During the traveling, the traveling wheel 31 passes over any two of the four intersection rails R3 described above. Alternatively, when the traveling vehicle 2 changes the traveling direction between the rail units 100 (changes the traveling direction by 90 degrees, i.e., turns), the traveling wheel 31 of the traveling vehicle 2 passes over the intersection travel surface R3a (while changing the direction).

As described above, in the rail assembly 200, the first rail member 110, the second rail member 120, and the intersection rail member 130 constitute the track R in a grid. The layout of the track R configured in a grid in the overhead vehicle system 1 may be adjusted or modified as appropriate by providing the rail units 100 in any desired arrangement (including adding or deleting of the rail unit 100).

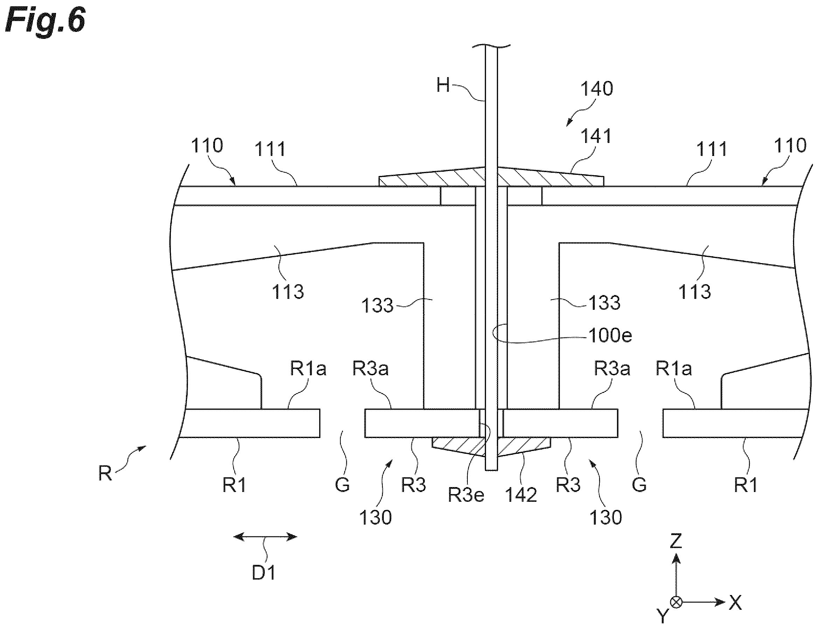

Referring to FIGs. 2 and 6, the connection structure of the rail unit 100 with the connecting member 140 is described. As illustrated in FIGs. 2 and 6, each of the connecting members 140 includes an upper connecting member 141 and a lower connecting member 142. The upper surface of any one of the four corners of the plurality of (typically four) rail units 100 is attached to an upper connecting member 141 of a plate shape or a frame shape extending horizontally. The upper connecting member 141 is in contact with the vicinity of the intersection of the first beam portion 111 and the second beam portion 121 in each of the rail units 100. The lower connecting member 142 of a plate shape or a frame shape extending horizontally supports the lower surface of any one of the four corners of the plurality of (typically four) rail units 100. The lower connecting member 142 is in contact with the intersection rail R3 in each of the rail units 100.

A hanging member H of a bar shape extending in the vertical direction penetrates through the upper connecting member 141 and the lower connecting member 142. The upper connecting member 141 and/or the lower connecting member 142 are fixed to the rail unit 100 by an unillustrated fastening member or the like, and thereby the rail units 100 are connected to each other. Note that a space 100e extending in the Z direction is formed between the rail units 100, and a space R3e extending in the Z direction is formed between the four intersection rails R3 adjacent to each other in the X and Y directions (center portion in plan view). The hanging member H is inserted into the space 100e and the space R3e, and the upper connecting member 141 and/or the lower connecting member 142 are fixed to the hanging member H.

The overhead vehicle system 1 includes a communication system (not illustrated). The communication system is used for communication between the traveling vehicle 2 and the system controller 5. The traveling vehicle 2 and the system controller 5 are each communicatively connected via a communication system.

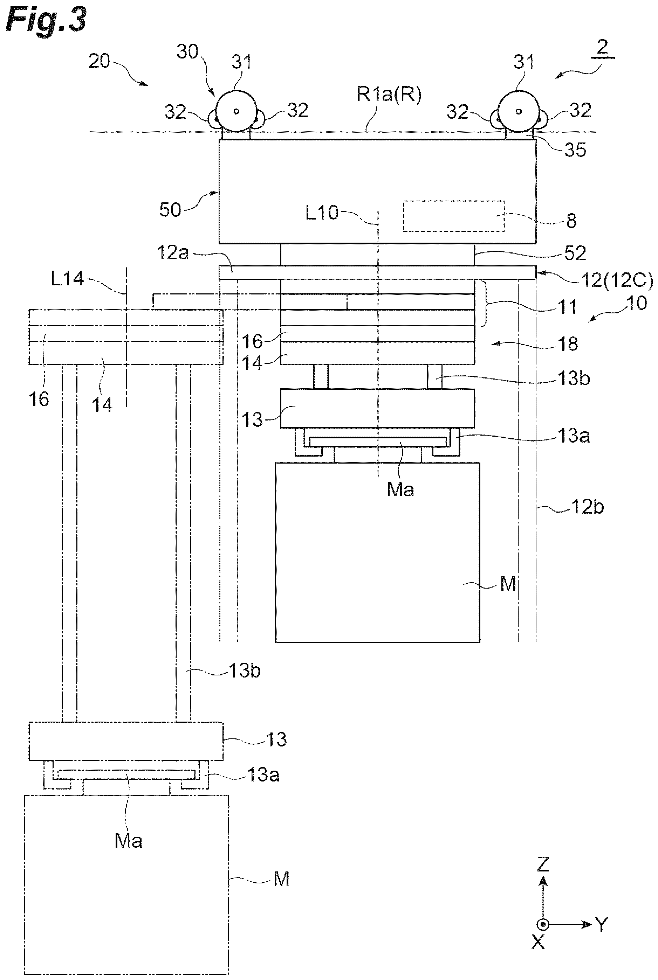

The configuration of the traveling vehicle 2 is then described with reference to FIGs. 1, 3 and 4. As illustrated in FIGs. 1 and 3, the traveling vehicle 2 is provided to be able to travel along a track R. The traveling vehicle 2 has a traveling cart 20 configured to travel on the track R and a body 10 configured to be attached to a bottom part of the traveling cart 20 and can swivel freely with respect to the traveling cart 20. The traveling cart 20 includes a cart unit 50 of a rectangular shape, for example, disposed below the track R, traveling parts 30 provided at the four corner positions of the cart unit 50 in plan view and protruding upward from the cart unit 50, and four wheel swivel mechanisms 40 configured to swivel the four traveling wheels 31 in the traveling parts 30, respectively, with respect to the cart unit 50. Inside the cart unit 50, a cart controller (control section) 8 is provided.

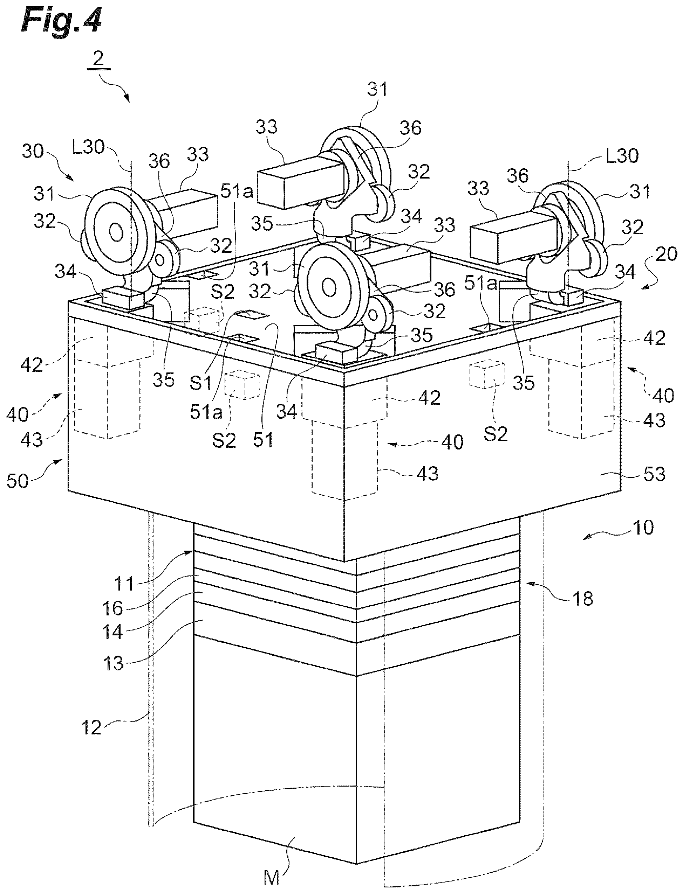

The body 10 is disposed below the track R. As illustrated in FIGs. 3 and 4, the body 10 has a body frame 12 formed in a cylindrical shape, for example. The body frame 12 includes a top panel part 12a of a disc shape and a cylindrical frame 12b hanging from a periphery of the top panel part 12a, and has an open lower surface. The body 10 is formed to dimensions fitting into one square in the track R (see FIG. 1) in plan view. The traveling vehicle 2 can pass another traveling vehicle 2 traveling on the adjacent first rail R1 or the adjacent second rail R2. The body 10 includes a transfer device 18 disposed inside the body frame 12. The transfer device 18 has a rectangular shape in plan view, for example. The cylindrical frame 12b is open in part of a circumferential direction. An area in which an open portion (cutout) is formed is large enough to allow the transfer device 18 to pass through. The transfer device 18, when moving horizontally, passes through the open portion of the cylindrical frame 12b.

The body 10 is attached to the bottom part of the cart unit 50 and can swivel around a rotation axis L10 in the Z direction with respect to the cart unit 50. The traveling wheels 31 at the four corner positions of the cart unit 50 are on the track R (on the first travel surface R1a, the second travel surface R2a, or the intersection travel surface R3a). The cart unit 50 is hung from the track R via the four traveling wheels 31 and the four wheel swivel mechanisms 40. The four traveling wheels 31 allow the cart unit 50 and the body 10 to hang stably and the body 10 to travel stably. In other words, the traveling vehicle 2 is hung and supported by the traveling wheels 31 traveling along the track R and moves below the track R.

The transfer device 18 moves horizontally with respect to the body 10 and transfers the articles M to and from a load port (placing platform). The transfer device 18 is provided below the top panel part 12a of the body frame 12. The body 10 including the transfer device 18 is rotatable around the rotation axis L10 by a rotation drive section (horizontal swiveling mechanism)12c such as an electric motor provided in the top panel part 12a. The transfer device 18 has an article holding section 13 configured to hold an article M on an underside of the track R, a lifting drive section 14 configured to raise and lower the article holding section 13 in the vertical direction, and a slide mechanism 11 configured to slide the lifting drive section 14 in the horizontal direction. The slide mechanism 11 is held on the lower surface of the top panel part 12a. Between the slide mechanism 11 and the lifting drive section 14, a rotation drive section 16 is configured to rotationally drive the lifting drive section 14, with respect to the slide mechanism 11, around the rotation axis L14. The rotation drive section 16 is provided below the slide mechanism 11, and the lifting drive section 14 is provided below the rotation drive section 16. The article holding section 13 is provided below the lifting drive section 14 via a plurality of the hanging members 13b. The load port is a transfer destination or a transfer source of the traveling vehicle 2 and a point at which the articles M are transferred to or from the traveling vehicle 2.

The article holding section 13 grips a flange part Ma of the article M, thereby hanging and holding the article M. The article holding section 13 is, for example, a chuck having a claw part 13a configured to be movable in the horizontal direction. The article holding section 13 advances the claw part 13a below the flange part Ma of the article M to raise the article holding section 13, thereby holding the article M. The article holding section 13 is connected to the hanging member 13b, such as a wire or belt.

The lifting drive section 14 is, for example, a hoist, the hoist lowering the article holding section 13 by unrolling the hanging member 13b and raising the article holding section 13 by reeling in the hanging member 13b. The lifting drive section 14 is controlled by the cart controller 8 to lower or raise the article holding section 13 at a predetermined speed. In addition, the lifting drive section 14 is controlled by the cart controller 8 to hold the article holding section 13 at a target height.

The slide mechanism 11 has a plurality of movable plates disposed on top of each other in the Z direction, for example. By causing the body 10 to swivel, the slide mechanism 11 moves the rotation drive section 16, the lifting drive section 14, and the article holding section 13 attached to the lowest movable plate in any desired direction in the horizontal plane. The swivel angle of the body 10 with respect to the cart unit 50 determines the direction of movement of the movable plate in the slide mechanism 11. In the body 10, the orientation of the transfer device 18 and the body frame 12 is set such that the direction of movement of the movable plate and the position of the open portion of the cylindrical frame 12b coincide.

The rotation drive section 16 includes, for example, an electric motor or the like and rotates the lifting drive section 14 (and the article holding section 13) within a predetermined angular range around the rotation axis L14 extending in the vertical direction. The angle that is rotatable by the rotation drive section 16 is any desired angle smaller than or equal to 180 degrees, for example, but the upper limit is not limited to 180 degrees. The rotation drive section 16 allows the article holding section 13 (or the article M held by the article holding section 13) held out sideways to be oriented in any desired direction. The slide mechanism 11 and the rotation drive section 16 are controlled by the cart controller 8. Note that even when the movable plate of the slide mechanism 11 has not moved and is stowed (in a state indicated by the solid line in FIG. 3), the lifting drive section 14 can be rotated by the rotation drive section 16. In that case, for example, the rotation axis L14 of the lifting drive section 14 coincides with the rotation axis L10 of the body 10.

The cart unit 50 has a support member 52 of a cylindrical shape (cylindrical member) at the lower end. The top plate 12a of the body frame 12 is attached in a rotatable manner to the lower surface side of the support member 52. For example, a rotation drive section 12c, such as an electric motor, is provided in the top plate 12a. The driving force of the rotation drive section 12c is transmitted to the support member 52, and thereby the body frame 12 rotates around the rotation axis L10 extending in the vertical direction with respective to the cart unit 50. The angle at which the body frame 12 is rotatable is any desired angle between 360 degrees and 540 degrees, for example, but the upper limit is not limited to 540 degrees and the lower limit is not limited to 360 degrees. The slide mechanism 11 is attached to the lower surface side of the top plate 12a, and the top plate 12a supports the slide mechanism 11. The body frame 12 and the transfer device 18 are integrated, and the body frame 12 and the transfer device 18 rotate together. The traveling vehicle 2 can receive and deliver the article M from and to the load port by using the transfer device 18.

Note that an unillustrated cover may be attached to an outer surface side of the cylindrical frame 12b. In that case, the cover encloses the transfer device 18 and the article M held in the transfer device 18. The cover has a cylindrical shape with its lower end open and has a cutout shape where the movable plate of the slide mechanism 11 protrudes therefrom (the open portion described above).

The traveling part 30 has four traveling wheels 31. Each of the traveling wheels 31 is provided with two auxiliary wheels 32. As illustrated in FIG. 4, the traveling wheels 31 are provided at the four corner positions of the cart unit 50 to protrude upward from the upper surface cover **51.** Each of the traveling wheels 31 is rotatable around the horizontal or nearly horizontal axle along the XY plane. On a rotation shaft of each of the traveling wheels 31, a traveling drive motor 33 is provided. Each of the traveling wheels 31 is rotationally driven by the driving force of the traveling drive motor 33. The traveling drive motor 33, for example, is configured to be switchable between forward rotation and reverse rotation. Each of the traveling wheels 31 rolls on the track R. Each of the traveling wheels 31 rolls on the travel surfaces R1a, R2a, and R3a of the first rail R1, second rail R2, and intersection rail R3 to drive the traveling vehicle 2. It is not limited in that all of the four traveling wheels 31 are rotationally driven by the driving force of the traveling drive motor 33, but there may be a configuration in which some of the four traveling wheels 31 are rotationally driven.

The traveling wheels 31 of the traveling part 30 travel on the first traveling surface R1a of the pair of first rails R1 adjacent to each other in the Y direction, whereby the traveling vehicle 2 moves in the X direction. In addition, the traveling wheels 31 of the traveling part 30 travel on the second running surface R2a of the pair of second rails R2 adjacent to each other in the X direction, whereby the traveling vehicle moves in the Y direction.

The four wheel swivel mechanisms 40 are fixed to an unillustrated frame inside the cart unit 50, and a base part 34 is connected to each of the wheel swivel mechanisms 40 via a swivel shaft of the wheel swivel mechanism 40. On the base part 34, the traveling wheel 31, the two auxiliary wheels 32, and the one traveling drive motor 33 are attached via a connecting part 35 and a support member 36. For example, an upper surface cover 51 of a square shape is provided on the upper surface of a housing 53, and the base parts 34 are disposed in cutouts formed in the four corners of the upper surface cover 51. The connecting part 35, the traveling wheels 31, the auxiliary wheels 32, and the traveling drive motor 33 are disposed above the upper surface cover 51.

As illustrated in FIGs. 3 and 4, the connecting part 35 connects the cart unit 50 (in detail, the wheel swivel mechanism 40 fixed in the cart unit 50) to the traveling wheels 31. With this connection structure, the cart unit 50 and the body 10 are disposed below the track R and in a state of being hung from the traveling part 30. The connecting part 35 is formed to be thick enough to pass through the gaps G between the first rail R1 and the intersection rail R3, and between the second rail R2 and the intersection rail R3. The support member 36 is provided in the top part of the connecting part 35 and supports in a rotatable manner the rotation shaft of the traveling wheel 31 and a rotation shaft of the auxiliary wheel 32. The support member 36 holds a relative position of the traveling wheel 31 and the auxiliary wheel 32.

As illustrated in FIG. 4, the traveling wheels 31 are provided in a swivelable manner around a swivel axis L30 extending in the vertical direction. The four swivel axes L30 are disposed at the apexes of a square in plan view, and the rotation axis L10 is placed at the center of the swivel axes L30. In other words, the four swivel axes L30 are disposed on four times symmetrical positions with respect to the rotation axis L10 of the body 10. In plan view, the position of the traveling wheel 31 is different (displaced) from the position of the swivel axis L30. The traveling wheel 31 can swivel by the wheel swivel mechanism 40, and thus can change the traveling direction of the traveling vehicle 2.

The auxiliary wheels 32 are disposed one each in front of and behind the traveling wheel 31 in the traveling direction. Each of the auxiliary wheels 32 is rotatable around the axis of a horizontal or nearly horizontal axle along the XY plane. The lower end of the auxiliary wheel 32 is set higher than the lower end of the traveling wheel 31, for example. Therefore, when the traveling wheels 31 are traveling on the travel surfaces R1a, R2a, and R3a, the auxiliary wheels 32 do not contact the travel surfaces R1a, R2a, and R3a. In addition, when the traveling wheels 31 pass through the gaps G between the first rail R1 and the intersection rail R3, and between the second rail R2 and the intersection rail R3, the auxiliary wheels 32 contact the auxiliary members, which are not illustrated, provided on the first rail R1 and the second rail R2 to prevent the traveling wheels 31 from falling. It is not limited to the provision of the two auxiliary wheels 32 on one traveling wheel 31, but one auxiliary wheel 32 may be provided on one traveling wheel 31, or the auxiliary wheel 32 may not be provided, for example.

The four wheel swivel mechanisms 40 are disposed, for example, at the four corner positions in the housing 53 of the cart unit 50. Each of the wheel swivel mechanism 40 has a steering motor 43, and a drive force transmission section 42 provided between the steering motor 43 and the traveling wheel 31. The drive force transmission section 42 is fixed to an unillustrated frame inside the cart unit 50. The drive force transmission section 42 is connected to the base part 34 via the swivel shaft. Each of the wheel swivel mechanisms 40 swivels the base part 34, the connecting part 35, the support member 36, the traveling wheel 31, the auxiliary wheel 32, and the traveling drive motor 33 in unison around the swivel axis L30. In a state where the traveling vehicle 2 is positioned in the center of each rail unit 100, each of the traveling wheels 31 is swiveled 90 degrees around the corresponding swivel axis L30. Consequently, the traveling wheels 31 swivel on the intersection rail R3. Consequently, the traveling vehicle 2 can turn. To turn is to switch from a first state in which the traveling vehicle 2 travels in the first travel direction D1 to a second state in which the traveling vehicle 2 travels in the second travel direction D2, or from the second state in which the traveling vehicle 2 travels in the second travel direction D2 to the first state in which the traveling vehicle 2 travels in the first travel direction D1. A turn of the traveling vehicle 2 is performed, for example, when the traveling vehicle 2 is at a standstill. The turn of the traveling vehicle 2 may be performed when the traveling vehicle 2 is stopped but the articles M are moving (for example, swiveling). The drive of the wheel swivel mechanism 40 is controlled by the cart controller 8.

As described above, the gap G is formed in the track R. When the traveling vehicle 2 travels on the first rail R1 and crosses the second rail R2, or when the traveling vehicle 2 travels on the second rail R2 and crosses the first rail R1, a part of the traveling vehicle 2 (in detail, for example, the connecting part 35) passes through the gap G.

Note that between the traveling wheel 31 and the wheel swivel mechanism 40 (for example, near the connecting part 35), the guide roller being in contact with a side of the intersection rail R3 may be provided. The guide roller prevents misalignment of the traveling cart 20 (traveling vehicle 2) with respect to the track R.

The traveling vehicle 2 includes one cell recognition sensor (first sensor) S1 and four position recognition sensors (second sensor) S2. In the example in FIG. 4, only three of the four position recognition sensors S2 are illustrated. The cell recognition sensor S1 and the position recognition sensors S2 are housed in the housing 53 of the cart unit 50. The cell recognition sensor S1 is disposed so that the detection direction is directed upward substantially perpendicular to the upper surface cover 51. The position recognition sensor S2 is disposed so that the detection direction is directed substantially upward. More precisely, the position recognition sensor S2 is disposed to be directed to a direction in which the detection direction is inclined outward from the center of the cell C with respect to the Z direction.

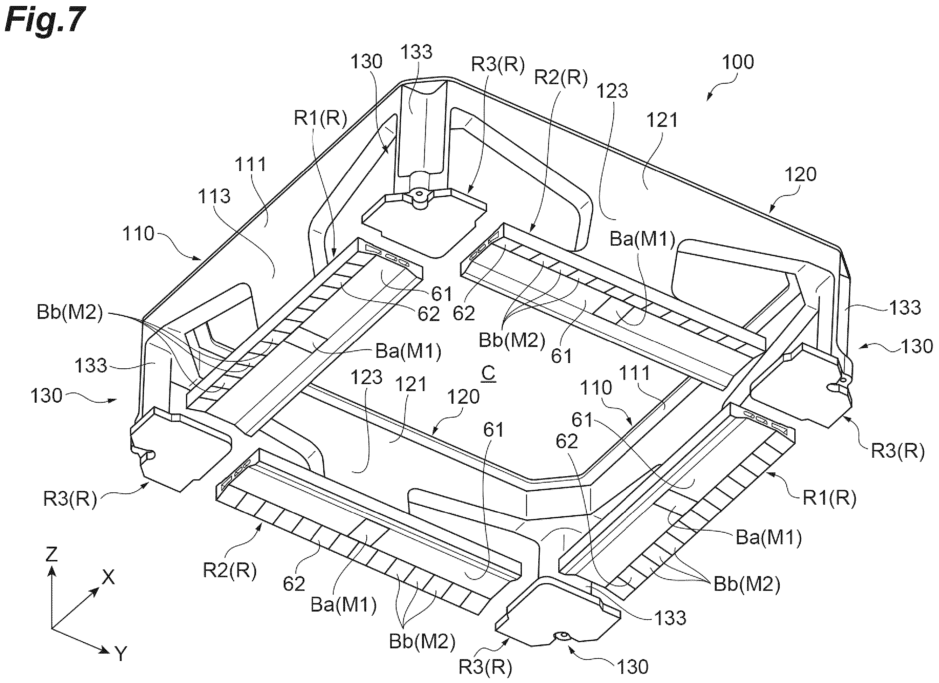

A cell recognition mark (first mark) M1 and position recognition marks (second marks) M2 are placed on the track R (refer to FIG. 7). The cell recognition sensor S1 detects the cell recognition mark M1 disposed on the track R in a noncontact manner. The position recognition sensor S2 detects the position recognition mark M2 disposed on the track R in a noncontact manner. The position recognition sensor S2 detects the position recognition mark M2 through a notch 51a in the upper surface cover 51. Details of the cell recognition mark M1 and the position recognition mark M2 are described below.

The cell recognition sensor S1 faces the cell recognition mark M1 when the traveling vehicle 2 is located at a predetermined position in the cell C (when stopped or traveling). At this time, the cell recognition sensor S1 acquires the information on the cell C (first information) from the cell recognition mark M1.

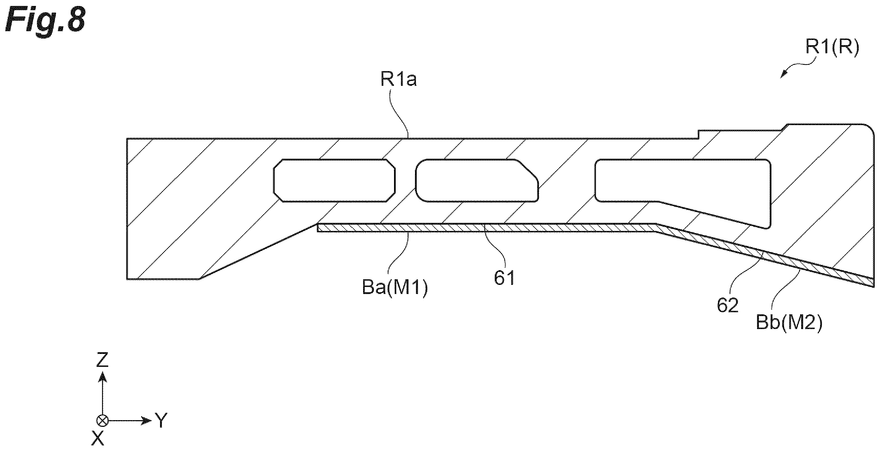

The position recognition sensor S2 is disposed, when the traveling vehicle 2 moves in the X direction, to face each of the second surfaces 62 (see FIG. 8) on which the position recognition mark M2 is disposed on each of the pair of first rails R1 included in the rail unit 100. In addition, the position recognition sensor S2 is disposed, when the traveling vehicle 2 moves in the Y direction, to face each of the second surfaces 62 on which the position recognition mark M2 is disposed on each of the pair of second rails R2 included in the rail unit 100. The position recognition sensor S2 acquires position information (second information) in the track R from the position recognition mark M2.

The cart controller 8 controls the traveling vehicle 2 in an overall manner. The cart controller 8 is a computer including a CPU (Central Processing Unit), ROM (Read Only Memory) and RAM (Random Access Memory), and the like. The cart controller 8 can be configured as software, for example, with which a computer program stored in ROM is loaded onto RAM and executed by the CPU. The cart controller 8 may be configured as hardware using an electronic circuit or the like. The cart controller 8 may include only a single device or include a plurality of devices. If the system includes a plurality of devices, connecting those devices via a communication network, such as the Internet or an intranet, logically constructs a single cart controller 8. The cart controller 8 is installed in the cart unit 50, for example.

The cart controller 8 controls the traveling of the traveling vehicle 2 based on transport instructions. The cart controller 8 controls the traveling of the traveling vehicle 2 by controlling the traveling drive motor 33 and the steering motor 43, and the like. The cart controller 8 controls, for example, travel speed, operations related to stopping, and operations related to direction changes. The cart controller 8 controls the transfer operation of the traveling vehicle 2 based on the transfer instructions. The cart controller 8 controls the swiveling (rotation) of the body 10 (the body frame 12 and the transfer device 18), and thereby controls the transfer direction of the transfer device 18. The cart controller 8 controls the transfer operation of the traveling vehicle 2 by controlling the transfer device 18 and the like. The cart controller 8 controls the operation of gripping the article M to be disposed at a specified load port, and the operation of unloading the held article M down to a specified load port.

The system controller 5 is a computer including a CPU, ROM and RAM, and the like. The system controller 5 can be configured as software, for example, with which a computer program stored in ROM is loaded onto RAM and executed by the CPU. The system controller 5 may be configured as hardware using an electronic circuit or the like. The system controller 5 may include only a single device or include a plurality of devices. If the system controller 5 includes a plurality of devices, connecting those devices via a communication network, such as the Internet or an intranet, logically constructs a single system controller 5. At least some of various controls of the system controller 5 may be performed by the cart controller 8.

The system controller 5 selects any of the traveling vehicles 2 configured to be able to transport the articles M and assigns the transport instructions to the selected traveling vehicle 2. The transport instructions include a travel instruction causing the traveling vehicle 2 to travel to the load port, and an instruction to grab the articles M disposed at the load port or an instruction to unload the articles M being held to the load port.

FIG. 7 is a perspective view illustrating the rail unit 100 in FIG. 2. FIG. 8 is a schematic cross-sectional view of the first rail R1 when cut in a plane perpendicular to the X direction. The example in FIG. 7 illustrates one rail unit 100 viewed from the negative side in the Z direction. Each of the first rail R1 and the second rail R2 included in the rail unit 100 has a first surface 61 and a second surface 62.

First, the first rail R1 will be described. In the present embodiment, the first surface 61 is orthogonal to the Z direction. The first surface 61 is parallel to the first traveling surface R1a in the Z direction. The shape of the first surface 61 is a rectangle shape extending in the X direction in plan view. The first surface 61 is formed to face the cell recognition sensor S1 of the traveling vehicle 2. The first surface 61 is formed so that the traveling vehicle 2 can travel in the X direction with the cell recognition sensor S1 of the traveling vehicle 2 facing the first surface 61.

On the first surface 61, the cell recognition mark M1 is disposed to indicate the information on the cell C. It can be said that the cell recognition mark M1 indicates information about which cell is which of the cells C constituted by the track R. The information on the cell C may be an ID uniquely identifying the cell C, or may be information about the location of the cell C. In the present embodiment, the cell recognition mark M1 consists of a single barcode Ba. In the example in FIG. 7, the barcode Ba is disposed in the center of the first rail R1 (first surface 61) in the X direction. The cell recognition mark M1 faces the cell recognition sensor S1 in a state in which the traveling vehicle 2 is located in a predetermined position in the cell C. The cell recognition sensor S1 acquires information on the cell C from the cell recognition mark M1.

In the present embodiment, the predetermined position refers to the cell center. A state in which the traveling vehicle 2 is located at a cell center of the cell C means that the cart unit 50 is not shifted horizontally with respect to the cell C, and the cart unit 50 is not shifted in the rotational direction with respect to the cell C. The phrase "the cart unit 50 is not shifted horizontally with respect to the cell C" means that the center of the cart unit 50 is aligned with the center of the cell C in plan view. The phrase "the cart unit 50 is not shifted in the rotational direction with respect to the cell C" means that, in plan view, out of the four sides of the rectangular cart unit 50, each of the two sides extending in the X direction is parallel to the first rail R1 constituting the cell C, and each of the two sides extending in the Y direction is parallel to the second rail R2 constituting the cell C. The center of the first rail R1 or the center of cell C need not be strictly centered or a center, but may have a certain width.

The second surface 62 is disposed outside of the first surface 61 when viewed from the center of the cell C. The second surface 62 is inclined toward the traveling vehicle 2 side (vertically downward in the example in FIG. 7) with respect to the first surface 61. The shape of the second surface 62 is a rectangle shape extending in the X direction when viewed from a direction orthogonal to the second surface 62. The second surface 62 is formed to face the position recognition sensor S2 of the traveling vehicle 2. The second surface 62 is formed so that the traveling vehicle 2 can travel in the X direction with the position recognition sensor S2 of the traveling vehicle 2 facing the second surface 62.

On the second surface 62, the position recognition mark M2 indicating position information in the track R (first rail R1) is disposed. The position information in the first rail R1 may be information about the position in the X direction in the first rail R1, or may be information about the distance from the center of the first rail R1 (center of the cell) in the X direction. The information indicated by the position recognition mark M2 is different from information indicated by the cell recognition mark M1. In the present embodiment, the position recognition mark M2 is constituted of a plurality (fourteen as an example) of barcodes Bb arranged in the X direction. The barcodes Bb are arranged without gaps on the second surface 62 along the X direction. The position recognition mark M2 faces the position recognition sensor S2 in a state in which the traveling vehicle 2 is traveling or stopped along the first rail R1. The position recognition sensor S2 acquires position information on the first rail R1 from the position recognition mark M2.

Subsequently, the second rail R2 will be described. In the present embodiment, the configuration of the second rail R2 is identical to that of the first rail R1. Therefore, explanations duplicating those of the first rail R1 above are omitted where appropriate.

In the second rail R2, the first surface 61 is parallel to the second traveling surface R2a (see FIGS. 1, 2 and 5) in the Z direction. The shape of the first surface 61 is a rectangle shape extending in the Y direction in plan view. The first surface 61 is formed so that the traveling vehicle 2 can travel in the Y direction with the cell recognition sensor S1 facing the first surface 61. The barcode Ba, which is the cell recognition mark M1, is disposed on the first surface 61. In the example in FIG. 7, the barcode Ba is disposed in the center of the second rail R2 (first surface 61) in the Y direction.

The shape of the second surface 62 is a rectangle extending in the Y direction when viewed orthogonally to the second surface 62. The second surface 62 is formed so that the traveling vehicle 2 can travel in the Y direction with the position recognition sensor S2 of the traveling vehicle 2 facing the second surface 62. The position recognition mark M2 is disposed on the second surface 62. The position information in the second rail R2 may be information about the position in the Y direction in the second rail R2, or may be information about the distance from the center of the second rail R2 (center of the cell) in the Y direction. In the present embodiment, the position recognition mark M2 is constituted of a plurality (fourteen as an example) of barcodes Bb arranged in the Y direction. The barcodes Bb are arranged without gaps on the second surface 62 along the Y direction. The position recognition mark M2 faces the position recognition mark M2 in a state in which the traveling vehicle 2 is traveling or stopped along the second rail R2. The position recognition sensor S2 acquires position information on the second rail R2 from the position recognition mark M2.

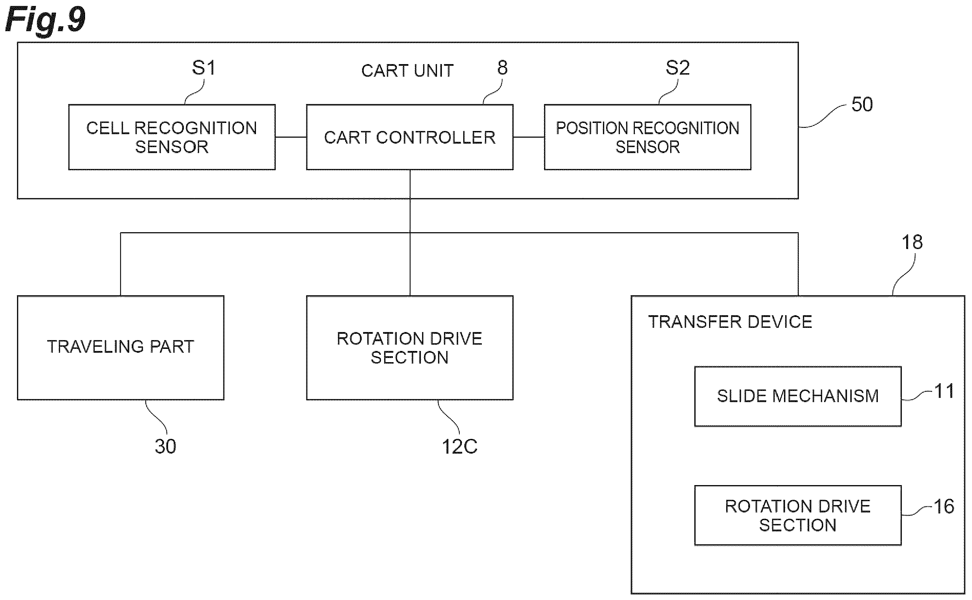

FIG. 9 is a block diagram illustrating a functional configuration of the traveling vehicle 2 in FIG. 3. The cart controller 8 acquires the detection results of the cell recognition sensor S1. Specifically, the cart controller 8 acquires information on the cell C acquired by the cell recognition sensor S1. In addition, the cart controller 8 also identifies the cell C in which the traveling vehicle 2 is located based on the information on the cell C.

The cart controller 8 acquires the detection results of the position recognition sensor S2. Specifically, the cart controller 8 acquires position information acquired by the position recognition sensor S2. In addition, based on the position information, the cart controller 8 derives the shift amount between the predetermined position in the cell C and the stop position of the traveling vehicle 2. The shift amount includes the shift amount in the horizontal direction (X and Y directions) and also the shift amount in the rotational direction around the Z direction.

The shift amount in the X direction can be derived, for example, by using the position information acquired by at least one of the two position recognition sensors S2 facing the second surface 62 of the first rail R1, and the position information of the center of the cell C stored in advance. In addition, the shift amount in the X direction can be derived by storing in advance a table in which the relationship between the position information indicated by the position recognition mark M2 and the above shift amount is correspondingly stored, and by performing a reading process of reading from the table the above shift amount corresponding to the position information indicated by the position recognition mark M2 acquired by the position recognition sensor S2. The shift amount in the Y direction can also be derived by the above calculation process or reading process in the same way as the shift amount in the X direction.

The shift amount in the rotational direction around the Z direction can be derived, for example, by a predetermined calculation process using four positional information acquired from two position recognition sensors S2 facing the second surface 62 of the first rail R1 and two position recognition sensors S2 facing the second surface 62 of the second rail R2. The shift amount in the rotational direction around the Z direction can be derived by executing a predetermined calculation process using at least the above three positional information. In addition, the shift amount in the rotational direction about the Z direction can be derived by storing in advance a table in which the relationship between the position information on each of the four rails constituting one cell C and the shift amount is stored, and by performing a reading process of reading from the table the shift amount corresponding to the three pieces of position information acquired by the position recognition sensor S2.

The cart controller 8 controls the slide mechanism 11 included in the transfer device 18 to move the article M horizontally. Specifically, the cart controller 8 controls the amount of movement of the article M by controlling the amount of movement of the movable plate of the slide mechanism 11. The cart controller 8, based on the shift amount in the horizontal direction, controls the drive amount of the slide mechanism 11 during moving of the article M in the horizontal direction.

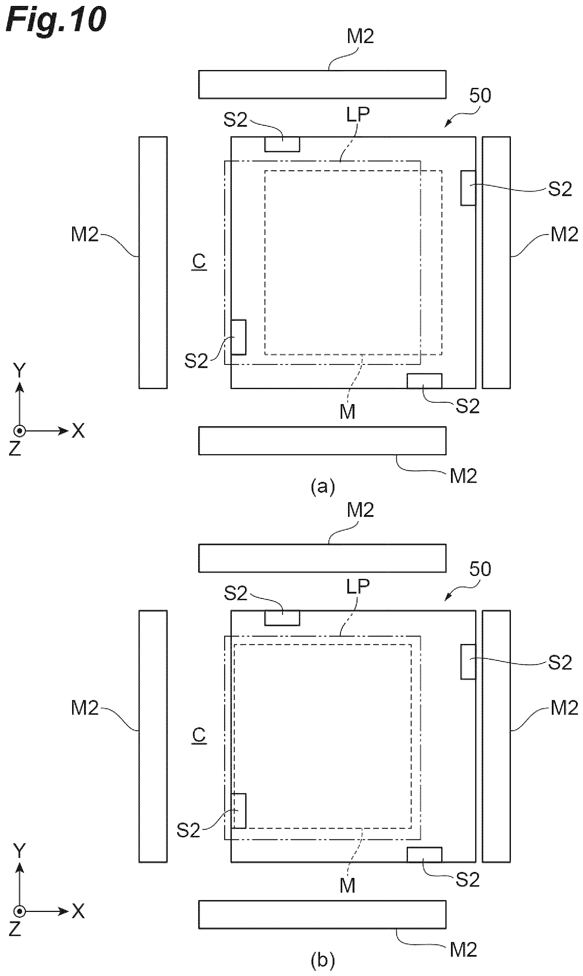

FIG. 10 is used to describe in more detail an example of the operation of the traveling vehicle 2 during placing of the article M onto the load port LP while controlling the drive amount of the slide mechanism 11. FIG. 10(a) illustrates a state in which the traveling vehicle 2, which is transporting the article M in the first traveling direction D1, stops at a position that is horizontally shifted with respect to a predetermined position in the cell C. Specifically, the stop position of the traveling vehicle 2 is shifted in the X direction with respect to the predetermined position. As a result, the position of the article M is shifted in the X direction with respect to the load port LP from which and to which the article M is received and delivered in plan view. In the example in FIG. 10, the load port LP is located directly below the center of the cell C in the vertical direction.

First, the two position recognition sensors S2 facing the second surface 62 of the pair of first rails R1 acquire position information in the first rail R1 from the position recognition mark M2. Next, the cart controller 8 derives the shift amount between the predetermined position in the cell C and the stop position of the traveling vehicle 2 based on the position information acquired by the two position recognition sensors S2.

Subsequently, the cart controller 8 moves the article M horizontally (X direction) by driving the slide mechanism 11. At that time, the cart controller 8 controls the amount of movement of the movable plate of the slide mechanism 11 based on the shift amount in the horizontal direction. As a result, the article M is moved in the X direction based on the shift amount derived by the cart controller 8. Thus, as illustrated in FIG. 10(b), the position of the article M with respect to the position of the load port LP is adjusted.

In addition, the cart controller 8 controls the rotation drive section 12c on the top plate 12a to horizontally swivel the transfer device 18 and the article M held by the transfer device 18 around the Z direction. Specifically, the cart controller 8 controls the amount of horizontal swiveling of the transfer device 18 and the article M held by the transfer device 18 by controlling the drive amount of the rotation drive section 12c. The cart controller 8 controls the drive amount of the rotation drive section 12c during horizontal swiveling of the article M based on the shift amount of the rotational direction derived as described above.

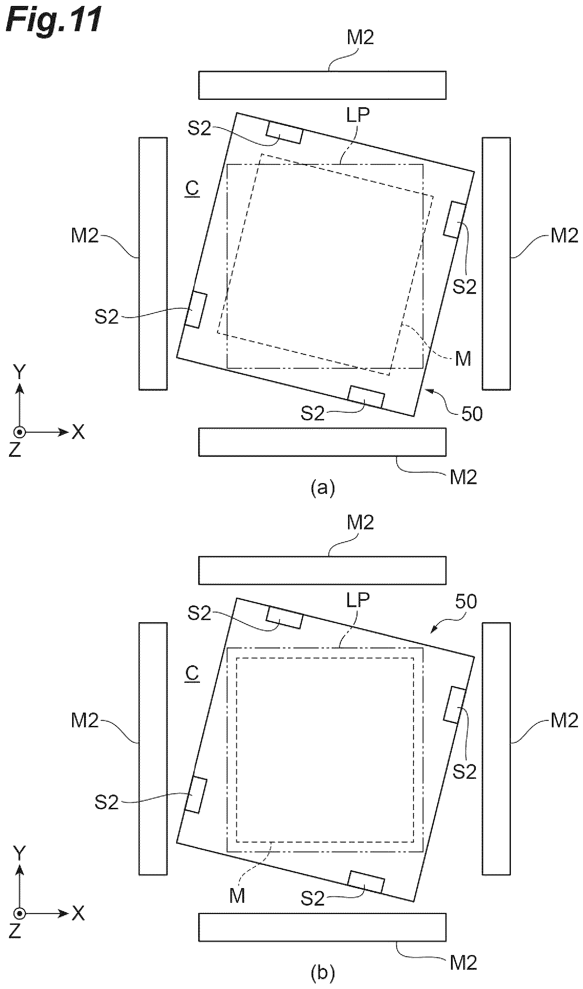

FIG. 11 is used to describe in more detail another example of the operation of the traveling vehicle 2 during placing of the article M onto the load port LP while controlling the drive amount of the rotation drive section 12c. FIG. 11(a) illustrates a state in which the traveling vehicle 2, which is transporting the article M, stops at a position that is shifted in the rotational direction with respect to a predetermined position in the cell C. Specifically, the stop position of the traveling vehicle 2 is shifted clockwise with respect to the predetermined position. As a result, the position of the article M is shifted clockwise with respect to the load port LP. In the example in FIG. 11, the load port LP is located directly below the center of the cell C in the vertical direction.

First, the four position recognition sensors S2 acquire position information from the position recognition marks M2. Next, the cart controller 8 derives the shift amount between the predetermined position in the cell C and the stop position of the traveling vehicle 2 based on the position information acquired by the four position recognition sensors S2.

Subsequently, the cart controller 8 drives the rotation drive section 12c provided on the top plate 12a to horizontally swivel the article M counterclockwise around the Z direction. At this time, the cart controller 8 controls the drive amount of the rotation drive section 12c based on the shift amount in the rotational direction. As a result, the article M is horizontally swiveled counterclockwise based on the shift amount derived by the cart controller 8. Thus, as illustrated in FIG. 11(b), the position of the article M with respect to the position of the load port LP is adjusted.

Subsequently, the effects of the overhead traveling vehicle system 1 according to the present embodiment are then described. In the above embodiment of the overhead traveling vehicle system 1, each of the first rail R1 and the second rail R2 forming the track R is provided with a first surface 61 and a second surface 62 different from the first surface 61, so that at least two types of marks different from each other can be disposed on respective surfaces, so that at least two types of marks different from each other can be disposed at the same location in the traveling direction of the track R. In addition, in the overhead traveling vehicle system 1 of this configuration, the second surface 62 disposed outside the first surface 61 when viewed from the center of the cell C in plan view is disposed to be inclined toward the traveling vehicle 2 side with respect to the first surface 61. Consequently, there is no need to provide for the position recognition sensor S2 to protrude from the traveling vehicle 2 in order to make the position recognition sensor face the second surface 62, thereby suppressing an increase in the size of the traveling vehicle 2.

The overhead traveling vehicle system 1 of the above embodiment further includes a cart controller 8 configured to control the traveling vehicle 2. Any one of the two types of marks different from each other is a position recognition mark M2 indicating position information in the track R, and the position recognition sensor S2 facing the position recognition mark M2 is disposed to correspondingly face the position recognition mark M2 disposed on each of the pair of first rails R1 when the traveling vehicle 2 moves in the X direction. In addition, the position recognition sensor S2 is disposed, when the traveling vehicle 2 moves in the Y direction, to correspondingly face the position recognition mark M2 disposed on each of the pair of second rails R2. Furthermore, the position recognition sensors S2 are four position recognition sensors S2 configured to acquire position information from the position recognition marks M2. The cart controller 8 derives the shift amount between the predetermined position in the cell C and the stop position of the traveling vehicle 2 based on the position information acquired by the position recognition sensors S2. In this case, the cart controller 8 can detect the position shift when the traveling vehicle 2 stops.

In the overhead traveling vehicle system 1 of the above embodiment, the traveling vehicle 2 has a transfer device 18 configured to transfer an article M. The cart controller 8 controls the drive amount of the transfer device 18 during moving of the article M in the horizontal direction (X and Y directions) based on the shift amount. In this case, even in a case in which the traveling vehicle 2 is not stopped at a predetermined position in the cell C, the position to which the article M is transferred by the transfer device 18 is adjusted, and thus the article M can be accurately transferred to the predetermined transfer position.

In the overhead traveling vehicle system 1 of the above embodiment, the traveling vehicle 2 has the transfer device 18 configured to transfer article M. The traveling vehicle 2 has a top plate 12a and a rotation drive section 16 configured to swivel the article M horizontally around the Z direction. The cart controller 8 controls, based on the shift amount, the drive amount of the rotation drive section 12c provided on the top plate 12a during horizontal swiveling of the article M and the rotation drive section 16 included in the transfer device 18. In this case, even in a case in which the traveling vehicle 2 is not stopped at a predetermined position in the cell C, the position to which the article M is transferred by the transfer device 18 is adjusted by the top plate 12a and the rotation drive section 16, and thus the article M can be transferred more accurately to the predetermined transfer position.

In the overhead traveling vehicle system 1 of the above embodiment, the cart controller 8 controls the traveling part 30 so that the traveling vehicle 2 moves to a predetermined position in the cell C based on the shift amount. In this case, even in a case in which the traveling vehicle 2 is not stopped at a predetermined position in the cell C, the position of the traveling vehicle 2 is adjusted, and thus the article M can be more accurately transferred to the predetermined transfer position.

Although the embodiment of one aspect of the present disclosure is described above, one aspect of the present disclosure is not limited to the above embodiment.

The above embodiment is described with an example of transferring the article M to a predetermined position of the load port LP in a configuration in which the load port LP is provided directly below the center of the cell C in the vertical direction, in a case in which the traveling vehicle 2 stops at a position that is shifted from the center of the cell C, by controlling the amount of movement of the movable plate of the slide mechanism 11 and/or the drive amount of the rotation drive section 12c, but this explanation is not limited to the example. The cart controller 8 may control the amount of movement of the traveling vehicle 2 along the X and Y directions by controlling the traveling part 30. Specifically, the cart controller 8 may control the drive amount of the traveling drive motor 33 configured to drive the traveling wheels 31 included in the traveling part 30. The cart controller 8 controls the traveling part 30 so that the traveling vehicle 2 moves to the predetermined position based on the shift amount in the horizontal direction and the rotational direction.

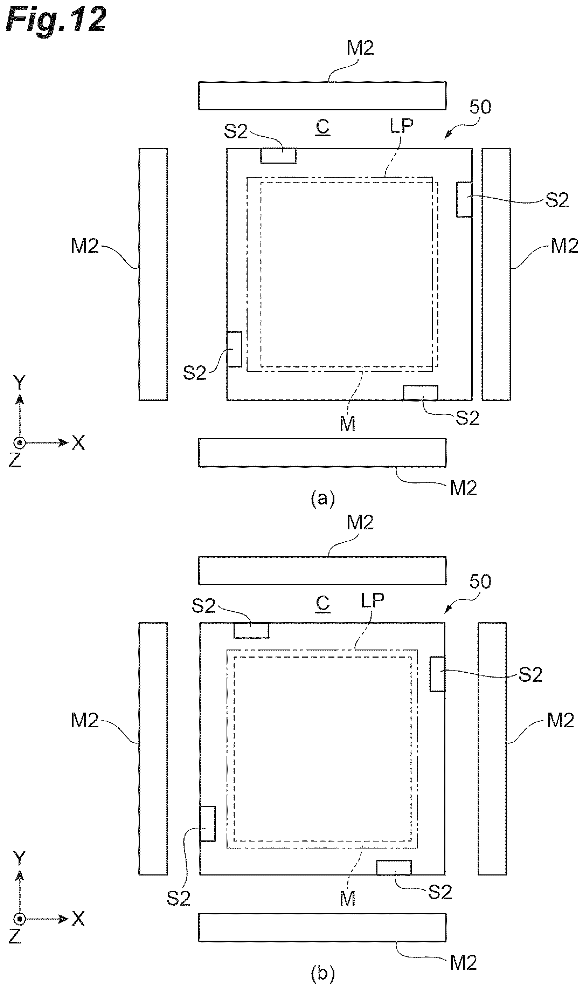

FIG. 12 is used to describe in more detail an example of the operation of the traveling vehicle 2 during placing of the article M onto the load port LP while controlling the drive amount of the traveling drive motor 33. FIG. 12(a) illustrates a state in which the traveling vehicle 2, which is transporting the article M in the first traveling direction D1, stops at a position that is horizontally shifted with respect to a predetermined position in the cell C. Specifically, the stop position of the traveling vehicle 2 is shifted in the X direction with respect to the predetermined position. As a result, the position of the article M is shifted in the X direction with respect to the load port LP. In the example in FIG. 12, the load port LP is also located directly below the center of cell C in the vertical direction.

First, the two position recognition sensors S2 facing the second surface 62 of the pair of first rails R1 acquire position information from the position recognition marks M2. Next, the cart controller 8 derives the shift amount between the predetermined position in cell C and the stop position of the traveling vehicle 2 based on the position information acquired by the two position recognition sensors S2.

Subsequently, the cart controller 8 moves the traveling vehicle 2 in the horizontal direction (X direction) by driving the traveling part 30. At that time, the cart controller 8 controls the drive amount of the traveling part 30 based on the shift amount in the horizontal direction. As a result, the article M is moved in the X direction based on the shift amount derived by the cart controller 8. Thus, as illustrated in FIG. 12(b), the position of the article M with respect to the position of the load port LP is adjusted.

The above embodiments and modifications are described with an example of transferring the article M to the load port LP in a configuration in which the load port LP is provided directly below the center of the cell C in the vertical direction, but is not limited thereto. For example, even in a case in which the load port LP is provided at a position that is shifted from the center of the cell C in plan view, as indicated in the above embodiment and the modification, it is possible to transfer the article M to the predetermined position of the load port LP by controlling the drive amount of the transfer device 18 during moving of the article M in the horizontal direction (X and Y directions) or by controlling the drive amount of the horizontal swiveling mechanism during horizontal swiveling of the article M, based on the above shift amount.

In addition, in a case in which the load port LP is provided at a position that is shifted from the center of the cell C in plan view, the cart controller 8 may move the article M in the horizontal direction by controlling the slide mechanism 11 included in the transfer device 18, and then may horizontally swivel the article M by controlling the rotation drive section 16 included in the transfer device 18 based on the shift amount derived as described above.

In the above embodiments and modifications, an example in which the traveling vehicle 2 holds the article M on the underside of the track R is described. However, the traveling vehicle 2 may hold the article M on the upper side of the track **R.** In this case, the cart unit 50 is disposed above the traveling part 30. The cell recognition sensor S1, for example, is disposed so as to be directed substantially downward with respect to the lower surface of the cart unit 50. The position recognition sensor S2 is, for example, disposed so as to be directed substantially downward. The position recognition sensor S2 is disposed so as to be directed to a direction inclined outward from the center of the cell C with respect to the Z direction. In addition, the first surface 61 is disposed to be perpendicular to the Z direction and to be directed upward, and the second surface 62 is disposed to be inclined toward the traveling vehicle 2 side (for example, vertically upward side in the example in FIG. 7) with respect to the first surface 61. As a result, the cell recognition sensor S1 faces the cell recognition mark M1 disposed on the first surface 61, and the position recognition sensor S2 faces the position recognition mark M2 disposed on the second surface 62.

The above embodiment describes a case in which the four swivel axes L30 in the traveling part 30 and wheel swivel mechanism 40 are disposed at the vertices of a square in plan view, but the disposition of the swivel axes L30 need not be square-shaped. In plan view, the position of the traveling wheels 31 may coincide with the position of the swivel axis L30.

In the above embodiment, the case in which the traveling wheel 31 rotates on the intersection rail R3 is described, but each of the traveling wheels 31 may transfer from the first travel surface R1a to the second travel surface R2a or from the second travel surface R2a to the first travel surface R1a when swiveling by the corresponding wheel swivel mechanism 40.

In the above embodiments and modifications, the case in which the cell recognition mark M1 is provided at the center of the first rail R1 in the X direction and at the center of the second rail R2 in the Y direction is described. However, the cell recognition mark M1 may be disposed along the extending direction similarly to the position recognition mark M2, for example, and as long as the location of the cell recognition mark M1 is detectable by the cell recognition sensor S1, the location of setting the cell recognition mark M1 is not particularly limited.

In the above embodiments and modifications, the case in which the cell recognition mark M1 is disposed on the first surface 61 and the position recognition mark M2 is disposed on the second surface 62 is described, but the disposition relationship of the marks may be reversed. In other words, the cell recognition mark M1 may be disposed on the second surface 62 and the position recognition mark M2 may be disposed on the first surface 61.

In the above embodiments and modifications, the case in which the four position recognition S2 sensors are installed in the traveling vehicle 2 is described, but the number of the position recognition sensors S2 can be changed as needed.

In the above embodiments and modifications, barcodes are used as examples of the cell recognition marks M1 and the position recognition marks M2, but they may be two-dimensional codes such as QR codes (registered trademarks), for example. In this case, instead of barcode readers capable of reading barcodes employed as the cell recognition sensors S1 and the position recognition sensors S2, barcode readers capable of reading two-dimensional barcodes may be employed. In addition, instead of, or in addition to, the above codes, an indication (mark) that can be identified by the cell recognition sensor S1 and the position recognition sensor S2, such as characters, symbols, figures, colors, and the like, may be employed as the cell recognition mark M1 and the position recognition mark M2. In this case, a camera or other devices may be employed as the cell recognition sensor S1 and the position recognition sensor S2.

### Reference Signs List

1... Overhead traveling vehicle system (tracked cart system)
2... Overhead traveling vehicle (tracked cart)
8... Cart controller (control section)
12c, 16... Rotation drive section (horizontal swiveling mechanism)
18... Transfer device
30... Traveling part
61... First surface
62... Second surface
C... Cell
M... Article (object)
M1... Cell recognition mark (first mark)
M2... Position recognition mark (second mark)
R... Track
R1... First rail
R2... Second rail
S1... Cell recognition sensor (first sensor)
S2... Position recognition sensor (second sensor)

## Claims

1. A tracked cart system, comprising:
a track in which a plurality of first rails extending in a first direction and a plurality of second rails extending in a second direction orthogonal to the first direction are disposed in a grid; and
a tracked cart configured to move in the first direction when a traveling part travels on a pair of the first rails adjacent to each other in the second direction, and to move in the second direction when the traveling part travels on a pair of the second rails adjacent to each other in the first direction, wherein
the tracked cart has
a first sensor configured to acquire first information from a first mark indicating the first information, and
a second sensor configured to acquire second information that is information different from the first information from a second mark indicating the second information,
each of the first rail and the second rail has
a first surface that faces the first sensor and on which the first mark is disposed, and
a second surface that faces the second sensor and on which the second mark is disposed, the second surface having, when viewed from a center of a cell serving as a space enclosed by the pair of first rails and the pair of second rails in plan view, the second surface that is disposed outside the first surface and is inclined on the tracked cart side with respect to the first surface.

2. A tracked cart system according to claim 1 further comprising a control section configured to control the tracked cart, wherein
either the first mark or the second mark is a position recognition mark indicating position information on the track,
either the first sensor or the second sensor configured to face the position recognition mark is disposed to face either the first surfaces or the second surfaces of the pair of first rails where the position recognition mark is disposed when the tracked cart moves in the first direction, is disposed to face either the first surfaces or the second surfaces of the pair of second rails where the position recognition mark is disposed when the tracked cart moves in the second direction, and has four position recognition sensors configured to acquire the position information from the position recognition mark, and
the control section is configured to, based on the position information acquired by the position recognition sensors, derive a shift amount between a predetermined position in the cell and a stop position of the tracked cart.

3. The tracked cart system according to claim 2, wherein
the tracked cart has a transfer device configured to transfer an object, and
the control section controls a drive amount of the transfer device during moving of the object in a horizontal direction based on the shift amount.

4. The tracked cart system according to claim 2, wherein
the tracked cart has the transfer device configured to transfer an object and a horizontal swiveling mechanism configured to horizontally swivel the object around a third direction orthogonal to both the first and the second directions, and
the control section controls the drive amount of the horizontal swiveling mechanism during horizontal swiveling of the object based on the shift amount.

5. The tracked cart system according to any one of claims 2 to 4, wherein the control section controls the traveling part so that the tracked cart moves to a predetermined position in the cell based on the shift amount.
